# FASCICULE DE BREVET EUROPEEN

(11) **EP 0 911 641 B1**
(45) Date de publication et mention de la délivrance du brevet: **15.12.2004**
(21) Numéro de dépôt: 98402608.8
(22) Date de dépôt: 20.10.1998
(51) Int. Cl.: G01R 31/316

(54) **Plage de test à positionnement automatique de microsonde et procédé de realisation d'une telle plage de test**
Testpad mit sich automatisch ausrichtender Mikrosonde und Verfahren zur Herstellung dafür
Test pad having an automatic positioning microprobe and method for realisation therefor

(30) Priorité: 22.10.1997 FR 9713233
(43) Date de publication de la demande: 28.04.1999
(73) Titulaire: STMicroelectronics S.A., 92120 Montrouge (FR)
(72) Inventeur: Vallet, Michel, 38410 Vaulnaveys le Haut (FR)
(74) Mandataire: Poulin, Gérard

(56) Documents cités:
- EP-A- 0 325 269
- US-A- 4 786 867
- US-A- 5 274 575
- PATENT ABSTRACTS OF JAPAN vol. 015, no. 448 (E-1133), 14 novembre 1991 & JP 03 190148 A (MITSUBISHI ELECTRIC CORP), 20 août 1991

## Description

### Domaine technique

La présente invention se rapporte à des plages de test pour des circuits électroniques intégrés.

Ces plages de test, formées généralement à la surface de substrats sont reliées électriquement à différentes parties des circuits pour effectuer des contrôles du bon fonctionnement de ces circuits.

Les contrôles consistent notamment en la mesure de tensions de contrôle continues au niveau des plages de test et sont effectués au moyen de microsondes.

Ces microsondes, reliées à des appareils de mesure appropriés, sont temporairement appliquées sur des plots de contact des plages de test pour effectuer les mesures.

Ainsi, l'invention trouve des applications dans le domaine technique de l'électronique et de la microélectronique, et notamment pour des dispositifs à circuits électroniques intégrés.

### Etat de la technique antérieure

Les plages de test des circuits électroniques de type connu se présentent sous la forme de plots de contact métalliques.

Ces plots de contact, généralement de forme carrée, présentent des dimensions de l'ordre de 20 µmx20 µm et sont disposés à la surface d'un substrat dans lequel sont formés un ou plusieurs circuits électroniques. Les plots de contact, entourés d'une couche isolante, dite de passivation, forment de légères protubérances à la surface du substrat.

Les plots de contact peuvent être reliés à des parties d'un circuit électronique formé à la surface du substrat mais aussi à des parties de circuits formés en profondeur dans le substrat. Ceci est le cas notamment lorsque le substrat est un substrat de type multicouche comportant un empilement de couches dites conductrices séparées par des couches isolantes. Dans ce cas, un plot de contact d'une plage de test formé à la surface du substrat peut être relié à un composant d'une couche conductrice profonde par l'intermédiaire de prises de contact, appelées "via" et traversant les couches isolantes.

Pour effectuer les mesures de contrôle des circuits électroniques, un outil équipé d'une ou de plusieurs microsondes est approché de la surface du substrat à une distance suffisamment faible pour que les extrémités des sondes viennent en contact avec le substrat.

Les microsondes se présentent sous la forme de fines languettes métalliques, généralement souples, comparables à des cheveux, qui viennent s'appuyer sur la surface du substrat.

Un dispositif de déplacement micrométrique, tel qu'un micropositionneur est alors activé pour effectuer un déplacement relatif des sondes et du substrat selon le plan du substrat. Ce déplacement est destiné à amener en coïncidence les extrémités des sondes sur les plots de contact des plages de test.

Le mouvement de déplacement relatif des sondes et du substrat peut être contrôlé par différents équipements tels que des systèmes de repérage optique ou des systèmes de vision à caméra CCD, comme décrit dans US 5 274 575 et US 4 786 867.

EP0 325 269 et JP 03 190148 décrivent des plots de contact utilisés pour aligner des sondes l'une par rapport à l'autre. Ces documents ne décrivent pas des moyens de guidage sur la plage de test pour positionner une sonde déplacée à la surface du substrat vers le plot de test.

La difficulté principale apparaissant lors de l'opération de contrôle des circuits, décrite ci-dessus, consiste dans le positionnement des extrémités des sondes exactement sur les plots de contact. Un mauvais positionnement des sondes peut provoquer en effet des mesures de contrôle erronées.

Une autre difficulté, liée essentiellement au caractère protubérant des plots de contact sur la surface du substrat, est de maintenir les extrémités des sondes sur les plots.

Pour faciliter le positionnement et le maintien des microsondes sur les plots de contact, une mesure bien connue est d'augmenter les dimensions des plots de contact.

Cependant, l'augmentation des dimensions et donc de l'aire des plots de contact métalliques à la surface du substrat s'accompagne d'une création ou d'une augmentation de capacités parasites.

En effet, les plots de contact des plages de test constituent des condensateurs avec les autres parties conductrices des circuits intégrés du substrat. Or, ces condensateurs présentent une capacité qui augmente avec l'aire des plots de contact. Ces capacités sont des capacités parasites qui modifient et altèrent le comportement des circuits électroniques. Ce problème est particulièrement gênant pour des circuits électroniques fonctionnant à haute fréquence.

A l'inverse, lorsque les dimensions des plots de contact sont réduites, afin de limiter les capacités parasites, des équipements coûteux d'ajustement des sondes sur les plots de contact doivent être mis en oeuvre, et le bon contact électrique entre les sondes et les plots de contact n'est pas toujours garanti.

De plus, le repérage à la surface du substrat de plots de contact de petites dimensions s'avère difficile.

### Exposé de l'invention

La présente invention a pour but de proposer un type nouveau de plages de test de circuit électronique permettant de résoudre les difficultés mentionnées ci-dessus.

Un but est en particulier de proposer une plage de test permettant un ajustage aisé et automatique des microsondes sur les plots de contact sans recourir à des dispositifs d'alignement complexes et coûteux.

Un autre but est de proposer des plages de test garantissant le maintien des extrémités des microsondes sur les plots de contact.

Un but de l'invention est encore de proposer des plages de test dont le repérage sur la surface du substrat est facilité.

Un but de l'invention est enfin de proposer un procédé particulièrement simple et peu coûteux pour la réalisation des plages de test.

Pour atteindre ces buts, l'invention a plus précisément pour objet une plage de test de circuit électronique comprenant un plot de contact formé à la surface d'un substrat, et des moyens de guidage d'une sonde de test, déplacée à la surface du substrat, vers ledit plot de contact.

Au sens de la présente description, on entend par circuit électronique aussi bien des circuits complets et complexes que des portions de circuit comprenant un ou plusieurs composants électroniques.

Grâce aux moyens de guidage, ménagés à la surface du substrat, il suffit que les sondes soient approximativement approchées du plot de contact, de façon à venir s'appuyer contre les moyens de guidage. En effet, lorsqu'une sonde est en appui contre un moyen de guidage vers le plot de contact, tout déplacement, même imprécis, de la sonde en direction du plot de contact résulte automatiquement en la mise en contact de l'extrémité de la sonde avec le plot de contact.

Grâce à cette caractéristique, des plots de contact de très faible surface peuvent être réalisés, sans compromettre la facilité de positionnement des microsondes sur ces plots. Or, en diminuant la surface des plots, la valeur des capacités parasites que les plots sont susceptibles d'engendrer, est également réduite.

Selon une réalisation particulière des moyens de guidage, ceux-ci peuvent comporter au voisinage du plot de contact, au moins un bossage allongé, formé à la surface du substrat, et orienté vers le plot de contact.

En particulier, les moyens de guidage peuvent comporter une pluralité de bossages allongés disposés de façon radiale autour du plot de contact.

En étant disposés tout autour du plot de contact, les bossages de guidage permettent d'éviter dans une certaine mesure que l'extrémité d'une sonde, appliquée sur le plot de contact, ne glisse à côté de ce plot. Ils constituent ainsi, en quelque sorte, un "verrouillage" de la sonde sur le plot de contact.

Cette fonction peut encore être améliorée lorsque, selon un aspect particulier de l'invention, le plot de contact est conçu de façon à former une dépression par rapport à la surface du substrat.

Les bossages allongés peuvent présenter un coeur métallique, isolé de préférence du plot de contact. Ils peuvent par ailleurs présenter un revêtement isolant sous la forme d'une couche de passivation. Le revêtement isolant présente, par exemple, une couche superficielle de nitrure de silicium, retenu non seulement pour ses bonnes caractéristiques d'isolation électrique, mais aussi pour sa bonne résistance à l'abrasion et à l'usure.

L'invention a également pour objet un circuit électronique comportant une ou plusieurs plages de test telles que décrites ici.

Enfin, l'invention a pour objet un procédé de réalisation d'une plage de test de circuit électronique à la surface d'un substrat. Le procédé comporte les étapes suivantes :
a) formation à la surface du substrat d'une couche de matériau conducteur électrique en contact électrique avec au moins une partie d'un circuit électronique du substrat,
b) mise en forme de la couche de matériau conducteur électrique pour définir un plot de contact, en contact électrique avec ladite partie du circuit électronique, et des bossages allongés, entourant le plot de contact et s'étendant radialement vers le plot de contact,
c) formation d'un revêtement isolant recouvrant la couche de matériau conducteur électrique mis en forme,
d) ouverture d'une fenêtre d'accès au plot de contact dans le revêtement isolant.

De préférence, pour des raisons d'alignement la fenêtre d'accès peut être réalisée avec des dimensions inférieures aux dimensions du plot de contact.

D'autres caractéristiques et avantages de l'invention ressortiront mieux de la description qui va suivre, en référence aux figures des dessins annexés. Cette description est donnée à titre purement illustratif et non limitatif.

### Brève description des figures

- La figure 1 est une vue de dessus d'une plage de test conforme à l'invention.
- La figure 2 est une vue latérale d'un détail d'une plage de test conforme à l'invention.
- La figure 3 est une coupe selon la ligne I-I de la plage de test de la figure 1.

### Exposé détaillé de modes de mise en oeuvre de l'invention

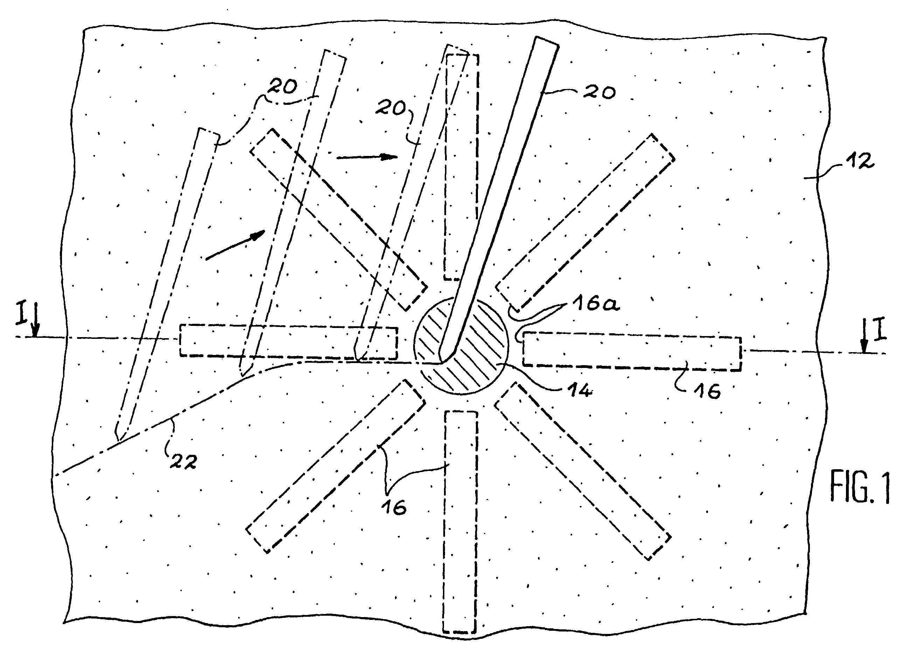

sur les figures 1 à 3, décrites ci-après, des parties identiques ou similaires portent respectivement les mêmes références.

La référence 12 sur la figure 1 représente une couche de matériau isolant, appelée encore couche de passivation, qui recouvre une surface d'un substrat comportant un ou plusieurs circuits intégrés.

Sur cette surface sont formées une ou plusieurs plages de test permettant de vérifier le bon fonctionnement des circuits ou des composants intégrés dans le substrat.

La description qui suit concerne plus particulièrement l'une des plages de test.

La plage de test comprend un plot de contact central 14 sensiblement rond, formé par la surface d'une pastille métallique d'un diamètre de l'ordre de 4 à 5 µm.

Les limites du plot de contact 14 sont définies par une ouverture circulaire pratiquée dans la couche de passivation 12, au-dessus de la pastille métallique dont une partie est ainsi mise à nu.

Le plot de contact est entouré, dans l'exemple décrit, de huit bossages allongés rectilignes 16. Ces bossages sont disposés au voisinage du plot 14 et orientés radialement vers le centre du plot. Les bossages 16, également recouverts de la couche de passivation, forment des saillies à la surface du substrat.

Comme on peut le constater sur la figure, les bossages 16 sont régulièrement espacés et leurs extrémités 16a tournées vers le plot de contact sont, de préférence, suffisamment espacées les unes des autres pour permettre le passage d'une microsonde glissant sur la surface du substrat.

La référence 20 indique une microsonde déplacée à la surface du substrat et ayant atteint le plot de contact. L'extrémité de la microsonde 20, sur la figure 1, est en contact électrique avec le plot de contact 14. Sur la figure 1 sont également représentées en trait discontinu, des positions antérieures de la microsonde 20. Ces positions antérieures de la sonde, ainsi que des flèches, permettent de montrer le déplacement relatif de la microsonde par rapport au substrat.

Par ailleurs, la trajectoire 22 effectuée par l'extrémité de la microsonde 20 à la surface du substrat est représentée en trait mixte.

Dans l'exemple de la figure 1, la microsonde 20 est déplacée initialement de façon approximative vers la plage de test, puis, après avoir buté contre un bossage 16, la trajectoire de la microsonde est infléchie pour être guidée directement vers le centre de la plage de test, sur le plot de contact.

Il apparaît qu'en l'absence de bossages, la trajectoire initiale de la microsonde risquait de faire passer l'extrémité de la sonde à côté du plot de contact.

Le rôle des bossages apparaît ainsi plus clairement : en prenant appui sur le bossage, l'extrémité de la sonde glisse vers le plot de contact, en dépit d'un mouvement approximatif de la sonde vers le centre de la plage de test.

Par ailleurs, les extrémités proximales 16a des bossages 16 entourant le plot de contact 14 évitent dans une certaine mesure que l'extrémité de la microsonde 20 n'échappe du plot de contact. Le maintien de l'extrémité de la microsonde sur le plot de contact 14 est également assuré par la couche de passivation et plus précisément par les bords de l'ouverture pratiquée dans la couche de passivation à l'endroit du plot de contact. Le plot de contact forme en effet une dépression par rapport à la couche de passivation 12 qui l'entoure.

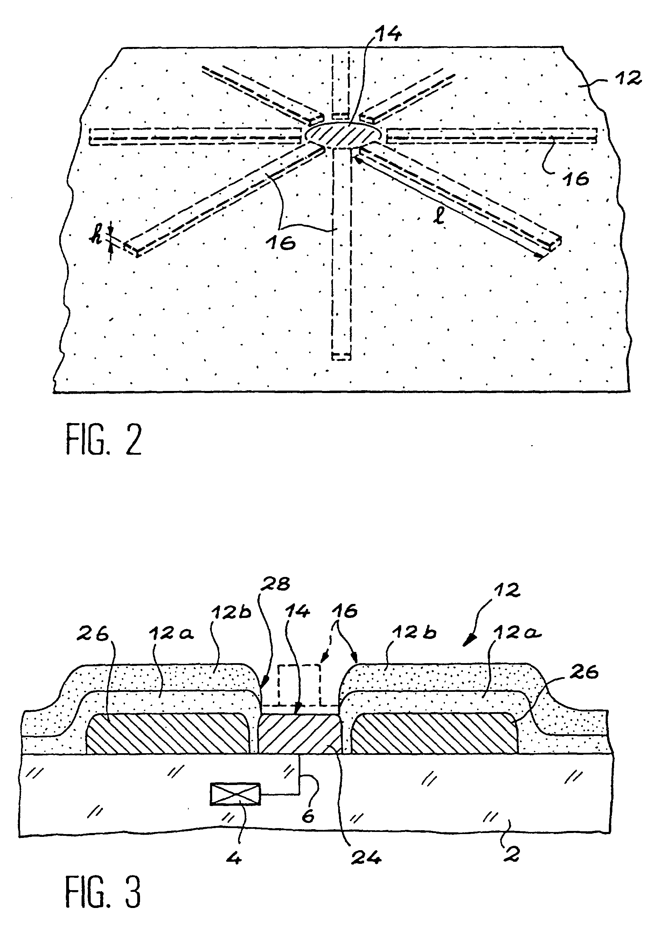

La figure 2 montre, selon une vue latérale, une partie de la surface du substrat et permet de mieux faire apparaître le caractère saillant des bossages 16 à la surface du substrat. Sur la figure la hauteur et la longueur des bossages de guidage 16 sont indiqués respectivement avec les lettres h et 1.

La hauteur h des bossages est, par exemple, de l'ordre de 1 µm et leur longueur est de l'ordre de 10 à 15 µm.

Ainsi, l'ensemble de la plage de test présente un diamètre de l'ordre de 25 à 35 µm. La plage de contact est ainsi facilement repérable en dépit des faibles dimensions du plot de contact central. Un plot central de faible surface, et présentant par conséquent une faible capacité parasite, peut être réalisé.

Par ailleurs, grâce à la disposition en étoile des huit bossages autour du plot central, les bossages forment entre eux un angle différent de 90° ou 180°. Un tel motif, non orthogonal, peut être facilement repéré à la surface du substrat. En effet, les éléments de circuit intégré visibles à la surface d'un substrat sont généralement agencés selon un réseau orthogonal, et, par rapport à un tel réseau, des motifs non orthogonaux peuvent être facilement identifiés. De façon générale, le repérage de la plage de test peut être facilité dès lors qu'au moins deux bossages forment entre eux un angle différent de 90° et de 180°.

La figure 3 permet de mieux comprendre la structure et la formation des bossages 16 à la surface du substrat. Elle montre en coupe deux bossages 16 disposés de part et d'autre du plot de contact central 14.

La référence 2 désigne un substrat dans lequel est formé un circuit électronique 4 représenté de façon très schématique.

Sur ce substrat est formée une couche métallique telle qu'une couche d'aluminium ou de cuivre par exemple. Cette couche est mise en forme par gravure pour y définir un pavé central 24 destiné à former le plot de contact, et pour y définir des pavés périphériques allongés formant respectivement un coeur 26 pour chaque bossage.

On observe que les coeurs métalliques 26 des bossages 16 sont électriquement isolés du pavé central 24.

Par ailleurs, la ligne 6 représente de façon schématique une liaison électrique entre un point particulier du circuit électronique intégré 4 et le pavé métallique central 24.

Une couche de matériau isolant 12, dite de passivation est ensuite formée sur l'ensemble de la structure, c'est-à-dire au-dessus des motifs métalliques et au-dessus de la partie du substrat 2 dépourvue de reliefs.

De façon plus précise, dans la réalisation illustrée à la figure 3, la couche de passivation 12 comporte deux sous-couches 12a et 12b formées dans cet ordre sur le substrat.

La première sous-couche 12a est une couche électriquement isolante d'oxyde de silicium tandis que la deuxième sous-couches 12b, qui constitue la surface supérieure de la structure est en nitrure de silicium. Ce matériau est choisi notamment pour ses propriétés isolantes électriques et ses propriétés de résistance à l'usure, afin de permettre un glissement aisé des microsondes 20 sur le substrat.

Enfin, une ouverture 28 est pratiquée dans la couche de passivation 12, c'est-à-dire dans les deux sous-couches 12a et 12b, à l'aplomb du pavé métallique 24. L'ouverture 28 permet de mettre à nu la partie supérieure du pavé métallique qui forme le plot de contact 14.

## Revendications

1. Plage de test de circuit électronique comprenant un plot de contact (14) formé à la surface d'un substrat (2), **caractérisé en ce qu'**elle comprend en outre des moyens (16) de guidage, servant d'appui à une sonde de test pouvant être déplacée à la surface du substrat, vers ledit plot de contact.

2. Plage de test selon la revendication 1, dans laquelle les moyens de guidage comportent au voisinage du plot de contact au moins un bossage (16) allongé, formé à la surface du substrat, et orienté vers le plot de contact.

3. Plage de test selon la revendication 2 dans laquelle les moyens de guidage comportent une pluralité de bossages (16) allongés disposés de façon radiale autour du plot de contact (14) .

4. Plage de test selon la revendication 3 dans laquelle les bossages (16) sont angulairement espacés avec un espacement sensiblement régulier.

5. Plage de test selon la revendication 3 ou 4 comportant au moins deux bossages allongés (16) formant entre eux un angle différent de 90° et de 180°.

6. Plage de test selon l'une des revendications 1 à 5, dans laquelle le plot de contact (14) est sensiblement rond.

7. Plage de test selon la revendication 1, dans laquelle le plot de contact (14) est entouré par une couche de matériau isolant (12).

8. Plage de test selon la revendication 2, dans laquelle le(s) bossage (s) (16) présente(nt) une couche superficielle (12b) de nitrure de silicium.

9. Plage de test selon la revendication 2, dans laquelle le(s) bossage(s) (16) présente(nt) un coeur métallique (26).

10. Circuit électronique comportant au moins une plage de test, **caractérisé en ce que** la plage de test est conforme à l'une quelconque des revendications précédentes.

11. Procédé de réalisation d'une plage de test de circuit électronique la surface d'un substrat, comportant les étapes suivantes :
a) formation à la surface du substrat d'une couche de matériau conducteur électrique en contact électrique avec au moins une partie d'un circuit électronique du substrat,
b) mise en forme de la couche de matériau conducteur électrique pour définir un plot de contact, en contact électrique avec ladite partie du circuit électronique et des bossages allongés, entourant le plot de contact et s'étendant radialement vers le plot de contact,
c) formation d'un revêtement isolant recouvrant la couche de matériau conducteur électrique mis en forme,
d) ouverture d'une fenêtre d'accès au plot de contact dans le revêtement isolant.

12. Procédé selon la revendication 11, dans lequel les bossages allongés (16) sont électriquement isolés du plot de contact (14).

13. Procédé selon la revendication 11, dans lequel le revêtement isolant comporte une couche d'oxyde de silicium (12a) recouverte d'une couche de nitrure de silicium (12b).

14. Procédé selon la revendication 11 dans lequel on réalise la fenêtre d'accès (28) avec des dimensions inférieures aux dimensions du plot de contact.

## Claims

1. Test area of an electronic circuit comprising a contact point (14) formed in the surface of a substrate (2), **characterized in that** it comprises in addition, guidance means (16) serving as a support for a test probe, displaceable on the surface of the substrate towards said contact point.

2. Test area according to claim 1, in which the guide means comprise, in proximity to the contact point, at least one elongated boss (16) formed on the surface of the substrate and oriented towards the contact point.

3. Test area according to claim 2, in which the guide means comprise a plurality of elongated bosses (16) arranged in a radial fashion around the contact point (14).

4. Test area according to claim 3, in which the bosses (16) are angularly spaced with a substantially regular spacing.

5. Test area according to claim 3 or 4 comprising at least two elongated bosses (16) forming between them an angle different from 90° and from 180°.

6. Test area according to one of claims 1 to 5, in which the contact point (14) is substantially round.

7. Test area according to claim 1, in which the contact point (14) is surrounded by a layer of insulating material (12).

8. Test area according to claim 2, in which the boss or bosses (16) has or have a surface layer (12b) of silicon nitride.

9. Test area according to claim 2, in which the boss or bosses (16) has or have a metal core (26).

10. Electronic circuit comprising at least one test area, **characterized in that** the test area conforms to any one of the preceding claims.

11. Method of producing a test area of an electronic circuit at the surface of a substrate comprising the following steps:
a) formation on the surface of the substrate of a layer of electrically conducting material in electrical contact with at least one part of an electronic circuit of the substrate,
b) shaping the layer of electrically conducting material in order to define a contact point, in electrical contact with said part of the electronic circuit and elongated bosses, surrounding the contact point and extending radially towards the contact point,
c) formation of an insulating layer covering the layer of shaped electrically conducting material,
d) opening of an access window to the contact point in the insulating layer.

12. Method according to claim 11, in which the elongated bosses (16) are electrically insulated from the contact point (14).

13. Method according to claim 11, in which the insulating covering comprises a layer of silicon oxide (12a) covered with a layer of silicon nitride (12b).

14. Method according to claim 1, in which the access window (28) is produced with dimensions smaller than the dimensions of the contact point.

## Patentansprüche

1. Testpad für eine elektronische Schaltung, umfassend ein an der Oberfläche eines Substrats (2) gebildetes Kontaktstück (14), **dadurch gekennzeichnet, dass** es ferner Führungsmittel (16) umfasst, die als Anlage für eine Testsonde dienen, welche an der Substratoberfläche zum Kontaktstück hin verlagerbar ist.

2. Testpad nach Anspruch 1, bei dem die Führungsmittel nahe dem Kontaktstück wenigstens einen länglichen Vorsprung (16) umfassen, der an der Substratoberfläche gebildet und zum Kontaktstück hin orientiert ist.

3. Testpad nach Anspruch 2, bei dem die Führungsmittel eine Mehrzahl von länglichen Vorsprüngen (16) umfassen, die radial um das Kontaktstück (14) herum angeordnet sind.

4. Testpad nach Anspruch 3, bei dem die Vorsprünge (16) angular mit einem im Wesentlichen gleichmäßigen Abstand beabstandet sind.

5. Testpad nach Anspruch 3 oder 4, umfassend wenigstens zwei längliche Vorsprünge (16), die miteinander einen von 90° und von 180° verschiedenen Winkel bilden.

6. Testpad nach einem der Ansprüche 1 bis 5, bei dem das Kontaktstück (14) im Wesentlichen rund ist.

7. Testpad nach Anspruch 1, bei dem das Kontaktstück (14) von einer Schicht aus Isoliermaterial (12) umgeben ist.

8. Testpad nach Anspruch 2, bei dem der Vorsprung/die Vorsprünge (16) eine Oberflächenschicht (12b) aus Siliziumnitrid aufweist/aufweisen.

9. Testpad nach Anspruch 2, bei dem der Vorsprung/die Vorsprünge (16) einen Metallkern (26) aufweist/aufweisen.

10. Elektronische Schaltung, umfassend wenigstens ein Testpad, **dadurch gekennzeichnet, dass** das Testpad einem der vorhergehenden Ansprüche entspricht.

11. Verfahren zur Herstellung eines Testpads für eine elektronische Schaltung an der Oberfläche eines Substrats, umfassend die folgenden Schritte:
a) Bilden einer Schicht aus elektrisch leitendem Material an der Substratoberfläche in elektrischem Kontakt mit wenigstens einem Teil einer elektronischen Schaltung des Substrats,
b) Formen der Schicht aus elektrisch leitendem Material, um ein Kontaktstück in elektrischem Kontakt mit dem Teil der elektronischen Schaltung zu definieren, sowie von länglichen Vorsprüngen, die das Kontaktstück umgeben und sich radial zum Kontaktstück hin erstrecken,
c) Bilden eines isolierenden Überzugs, der die in Form gebrachte Schicht aus elektrisch leitendem Material bedeckt,
d) Öffnen eines Fensters zum Zugang zum Kontaktstück im isolierenden Überzug.

12. Verfahren nach Anspruch 11, bei dem die länglichen Vorsprünge (16) elektrisch vom Kontaktstück (14) isoliert sind.

13. Verfahren nach Anspruch 11, bei dem der isolierende Überzug eine Siliziumoxidschicht (12a) umfasst, die von einer Siliziumnitridschicht (12b) bedeckt ist.

14. Verfahren nach Anspruch 11, bei dem man das Zugangsfenster (28) mit Abmessungen realisiert, die kleiner als die Abmessungen des Kontaktstücks sind.
